(19) Europäisches Patentamt
European Patent Office
Office européen des brevets

(11) **EP 4 112 149 A1**

(12) **EUROPÄISCHE PATENTANMELDUNG**

(43) Veröffentlichungstag:
**04.01.2023 Patentblatt 2023/01**

(21) Anmeldenummer: **22179097.5**

(22) Anmeldetag: **15.06.2022**

(51) Internationale Patentklassifikation (IPC):
**B01D 9/00** *(2006.01)* **G01N 27/02** *(2006.01)*

(52) Gemeinsame Patentklassifikation (CPC):
**B01D 9/0063; G01N 27/02**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **15.06.2021 EP 21179562**

(71) Anmelder: **Krohne Messtechnik GmbH**
**47058 Duisburg (DE)**

(72) Erfinder:
• **Förster, Jan**
**45149 Essen (DE)**
• **Brandenburg, Malte**
**45239 Essen (DE)**

(74) Vertreter: **Gesthuysen Patentanwälte**
**Huyssenallee 100**
**45128 Essen (DE)**

(54) **VORRICHTUNG ZUR REINIGUNG EINES PRODUKTES UND VERFAHREN ZUR REINIGUNG EINES PRODUKTES**

(57)    Beschrieben und dargestellt ist eine Vorrichtung (1) zur Reinigung eines Produktes mittels Kristallisation, wobei das Produkt vorzugsweise durch ein chemisches Verfahren hergestellt ist und wobei das Produkt einen Verunreinigungsanteil $\delta$ aufweist, umfassend eine Zuführeinheit (2) mit einem Lösemittel, wobei im Betrieb das Produkt über die Zuführeinheit (2) der Vorrichtung (1) zugeführt wird, sodass in der Zuführeinheit (2) die Gesamtproduktkonzentration $\alpha$ in dem Lösemittel vorliegt, eine Kristallisationseinheit (3), in der das Produkt im Betrieb kristallisiert und damit einen Feststoffanteil $\beta$ ausbildet, wobei ein weiterer Anteil des Produktes als gelöster Produktanteil $\gamma$ vorliegt, eine Trenneinheit (4), in der das kristallisierte Produkt von dem Lösemittel oder der Suspension getrennt wird, eine Temperiereinheit (6), über die die Temperatur zumindest in der Zuführeinheit (2) und/oder der Kristallisationseinheit (3) geregelt werden kann, und weiterhin umfassend eine Steuer- und Auswerteeinheit (7),
**dadurch gekennzeichnet,**
dass an wenigstens zwei Stellen der Vorrichtung (2) zumindest jeweils ein Temperatursensor (8) und jeweils ein Impedanzsensor (9) angeordnet ist, wobei die Temperatursensoren (8) und die Impedanzsensoren (9) mit der Steuer- und Auswerteeinheit (7) verbunden sind und dass die Steuer- und Auswerteeinheit (7) derart eingerichtet ist, dass sie im Betrieb die Gesamtproduktkonzentration $\alpha$ und/oder die Konzentration des Feststoffanteils $\beta$ und/oder die Konzentration des gelösten Produktanteils $\gamma$ und/oder die Konzentration des Verunreinigungsanteils $\delta$ unter Berücksichtigung der Messwerte der Temperatursensoren und der Impedanzsensoren

bestimmt.

Fig. 1

**Beschreibung**

Die Erfindung geht aus von einer Vorrichtung zur Reinigung eines Produktes mittels Kristallisation, wobei das Produkt vorzugsweise durch ein chemisches Verfahren hergestellt ist und wobei das Produkt einen Verunreinigungsanteil δ aufweist, umfassend

eine Zuführeinheit mit einem Lösemittel, wobei im Betrieb das Produkt über die Zuführeinheit der Vorrichtung zugeführt wird, sodass in der Zuführeinheit eine Lösung, in der eine Gesamtproduktkonzentration α im Wesentlichen vollständig gelöst, oder eine Suspension mit der Gesamtproduktkonzentration α vorliegt,

eine Kristallisationseinheit, in der das Produkt im Betrieb kristallisiert und damit einen Feststoffanteil β ausbildet, wobei ein weiterer Anteil des Produktes als gelöster Produktanteil γ vorliegt,

eine Trenneinheit, in der das kristallisierte Produkt aus der Lösung oder der Suspension herausgetrennt wird,

eine Temperiereinheit, über die die Temperatur zumindest in der Zuführeinheit und/oder der Kristallisationseinheit geregelt werden kann,

und weiterhin umfassend eine Steuer- und Auswerteeinheit.

Zudem betrifft die Erfindung ein Verfahren zur Reinigung eines Produktes mit einer erfindungsgemäßen Vorrichtung, wobei das Produkt vorzugsweise durch ein chemisches Verfahren hergestellt ist, und wobei das Produkt einen Verunreinigungsanteil δ aufweist.

Bei der Herstellung von Produkten mit chemischer Verfahrenstechnik (CVT) müssen diese Produkte in einem der letzten Produktionsschritte von den für die Herstellung benötigten Trägerstoffen und/oder Katalysatoren bereinigt bzw. getrennt werden, um eine ausreichend hohe Produktreinheit zu erzielen. Für eine solche Trennung bzw. Reinigung existieren unterschiedliche Methoden, die zu den jeweiligen Stoffen passen und nicht zwangsläufig beliebig gegeneinander getauscht werden können. Eine wichtige dieser Methoden ist die Trennung bzw. Reinigung mittels Kristallisation.

Bei der Kristallisation liegt das durch das Herstellungsverfahren verunreinigte Produkt (hier als Edukt bezeichnet) in einer Zuführeinheit in einem Lösemittel vollständig gelöst oder fein verteilt als heterogenes Stoffgemisch vor. Die Gesamtproduktkonzentration wird im Folgenden als α bezeichnet. Wird die Lösung oder die Suspension in einer Kristallisationseinheit in einen übersättigten Zustand, beispielsweise durch Abkühlung oder durch Verdunstung von Lösemittel, gebracht, wird Kristallbildung bzw. Kristallwachstum angeregt und ein Teil des zuvor gelösten Produkts kristallisiert nun zu Feststoff. Dieser Feststoffanteil wird im Folgenden als β bezeichnet, die verbleibende gelöste oder fein verteilte Produktkonzentration als γ. Da die Gesamt-Produktkonzentration trotz Kristallisation unverändert bleibt, gilt α = β + γ. Beim Kristallwachstum werden viele der zuvor am Edukt anhaftenden Verunreinigungen im entstehenden Feststoff nicht wieder eingebaut und verbleiben in der flüssigen Phase. Das auskristallisierte Produkt wird anschließend von der flüssigen Phase in einer Trenneinheit getrennt. Auf diese Weise wird das Endprodukt von ungewollten Fremdstoffen gereinigt und liegt in einer sehr hohen Reinheit vor. Zugleich wird die Verunreinigungskonzentration δ in der Lösung erhöht. Da in einer Ausführung die vom Feststoff abgetrennte Lösung (als sogenannte Mutterlauge) für das Auflösen der nächsten Portion des verunreinigten Produkts wiederverwendet wird, nimmt in zyklischen Systemen der Verunreinigungsanteil δ in der Zuführeinheit und der Kristallisationseinheit stetig zu, bis die Konzentration derart hoch ist, dass während des Kristallwachstums des zu reinigenden Produkts zu viele Verunreinigungen eingebaut werden, d.h. die Reinigungswirkung des Prozesses reduziert wird. Als Resultat liegt das Produkt dann nicht mehr in der geforderten Reinheit vor und muss entweder erneut einen Reinigungsprozess durchlaufen oder sogar verworfen werden. Ersteres bedeutet einen unnötigen Energieaufwand, Letzteres eine ungewollte Ressourcenverschwendung.

Für den Kristallisationsprozess wird Energie benötigt. Für das Auflösen des verunreinigten Produktes wird das Lösemittel beispielsweise erwärmt. Auf diese Weise kann ein hoher Anteil des Produkts im Lösemittel gelöst werden, ohne dass die Lösung oder die Suspension in Sättigung gelangt, da die Sättigungsgrenze mit steigender Temperatur zunimmt.

Beim nachfolgenden Schritt der erneuten Kristallisation wird die Lösung bzw. die Suspension schnell sehr stark heruntergekühlt (Kühlungskristallisation) oder auf den Siedepunkt erhitzt (Verdampfungskristallisation). In der chemischen Verfahrenstechnik werden im ersteren Fall häufig Temperaturrampen von mehreren 10 °C in wenigen Minuten angewendet, wofür eine große Kühlleistung benötigt wird. Die Lösung oder die Suspension wird dann nach Erreichen der Zieltemperatur für den Kristallisationsprozess so lange auf der Zieltemperatur gehalten, bis der Vorgang der Kristallisation abgeschlossen ist. Anschließend wird das kristallisierte Produkt an der Trenneinheit entnommen. Wird das Produkt nicht lange genug bei der Zieltemperatur gehalten, ist weniger Produkt auskristallisiert als technisch möglich, was sich als schlechte Effizienz des Prozesses auswirkt. Wird allerdings das Produkt länger als notwendig bei der Zieltemperatur gehalten, wird mehr Kühlenergie aufgebracht als notwendig, was ebenfalls die Effizienz des Prozesses reduziert.

Es ist daher wünschenswert, den Prozess der Kristallisation und insbesondere den Verlauf des Kristallwachstums zu überwachen.

Aus der Druckschrift CN 109030303 A ist es bekannt, den Prozess der Kristallisation durch Messung der elektrischen Impedanz zu überwachen.

Ausgehend von dem dargelegten Stand der Technik ist es daher Aufgabe der vorliegenden Erfindung, eine Vorrichtung zur Reinigung eines Produktes mittels Kristallisation anzugeben, die eine besonders effiziente Reinigung gewährleistet. Darüber hinaus ist es Aufgabe der Erfindung, ein besonders effizientes Verfahren zur Reinigung eines Produktes mittels Kristallisation anzugeben.

Gemäß einer ersten Lehre der Erfindung wird die Aufgabe durch eine eingangs beschriebene Vorrichtung dadurch gelöst, dass an wenigstens zwei Stellen der Vorrichtung jeweils ein Temperatursensor und ein Impedanzsensor angeordnet ist,

> wobei die Temperatursensoren und die Impedanzsensoren mit der Steuer- und Auswerteeinheit verbunden sind und

> dass die Steuer- und Auswerteeinheit derart eingerichtet ist, dass sie im Betrieb die Gesamtproduktkonzentration $\alpha$ und/oder die Konzentration des Feststoffanteils $\beta$ und/oder die Konzentration des gelösten Produktanteils $\gamma$ und/oder die Konzentration des Verunreinigungsanteils $\delta$ unter Berücksichtigung der Messwerte der Temperatursensoren und der Impedanzsensoren bestimmt.

Erfindungsgemäß wurde erkannt, dass den Kristallisationsprozess charakterisierende Prozessgrößen, wie insbesondere die Gesamtproduktkonzentration $\alpha$ und/oder die Konzentration des Feststoffanteils $\beta$ und/oder die Konzentration des gelösten Produktanteils $\gamma$ und/oder die Konzentration des Verunreinigungsanteils $\delta$ effizient erfasst und auch online überwacht werden können, wenn sowohl die Temperatur als auch die elektrische Impedanz an wenigstens zwei Stellen des Prozesses erfasst wird. Dabei berücksichtigt die Erfindung, dass sich durch den Kristallisationsprozess die elektrische Impedanz, und damit die Leitfähigkeit und/oder die Permittivität der Lösung oder der Suspension ändert.

Ändert sich im Verlauf der Kristallisation ebenfalls die Temperatur, kann eine auf die Temperaturänderung zurückzuführende Änderung der elektrischen Impedanz durch Messung der Temperatur kompensiert werden.

Die Erfindung weist damit den Vorteil auf, dass die zuvor genannten gewünschten Größen Gesamtproduktkonzentration $\alpha$ und/oder die Konzentration des Feststoffanteils $\beta$ und/oder die Konzentration des gelösten Produktanteils $\gamma$ und/oder die Konzentration des Verunreinigungsanteils $\delta$ online erfasst und überwacht werden können, sodass frühzeitig Maßnahmen ergriffen werden können, wenn die überwachten Größen von den erwarteten Zielwerten oder Zielbereichen abweichen.

Damit kann der Prozess der Reinigung eines Produktes besonders effizient gesteuert werden.

Gemäß einer ersten Ausgestaltung ist eine Rückführeinheit vorhanden, wobei die Trenneinheit über die Rückführeinheit mit der Zuführeinheit verbunden ist, sodass im Betrieb die Lösung oder die Suspension durch die Zuführeinheit in die Kristallisationseinheit in die Trenneinheit und durch die Rückführeinheit wieder in die Zuführeinheit fließt.

Beispielsweise ist die erfindungsgemäße Vorrichtung als Rohr ausgebildet, das die unterschiedlichen Abschnitte Zuführeinheit, Kristallisationseinheit, Trenneinheit und optional Rückführeinheit aufweist. Zudem kann die Vorrichtung auch eine Aneinanderreihung von einzelnen Behältern sein, die miteinander verbunden sind. Zudem kann die Vorrichtung ebenso als einzelner Behälter ausgebildet sein. In diesem Fall sind die einzelnen Einheiten durch den gemeinsamen Behälter realisiert.

Gemäß einer nächsten Ausgestaltung ist in der Zuführeinheit ein erster Impedanzsensor und ein erster Temperatursensor angeordnet und in der Kristallisationseinheit ist ein zweiter Impedanzsensor und ein zweiter Temperatursensor angeordnet und vorzugsweise ist in der Rückführeinheit, sofern diese vorhanden ist, ein dritter Impedanzsensor und ein dritter Temperatursensor angeordnet. Mit dieser Ausgestaltung können die zuvor genannten Parameter an verschiedenen Stellen des Prozesses erfasst und überwacht werden, wodurch eine besonders genaue Überwachung des Kristallisationsprozesses gewährleistet werden kann.

Besonders bevorzugt ist die Vorrichtung derart ausgebildet, dass die Steuer- und Auswerteeinheit im Betrieb eines der nachfolgend beschriebenen Verfahren ausführt.

Gemäß einer zweiten Lehre der vorliegenden Erfindung wird die eingangs dargelegte Aufgabe durch ein eingangs beschriebenes Verfahren zur Reinigung eines Produktes mit einer der zuvor beschriebenen Vorrichtungen, wobei das Produkt vorzugsweise durch ein chemisches Verfahren hergestellt ist, und wobei das Produkt einen Verunreinigungsanteil $\delta$ aufweist, dadurch gelöst,

> dass in einem Vorbereitungsschritt der Zusammenhang zwischen der elektrischen Impedanz der Lösung oder der Suspension und der Temperatur und/oder der Gesamtproduktkonzentration $\alpha$ in der Lösung oder der Suspension und/oder dem Feststoffanteil $\beta$ und/oder dem Verunreinigungsanteil $\delta$ erfasst wird,

> wobei aus dem erfassten Zusammenhang eine Kalibriermatrix bestimmt wird und

> dass während des Betriebs der Vorrichtung die folgenden Schritte durchgeführt werden:

- in einem Zuführschritt wird der Zuführeinheit das Produkt zugeführt, wobei das Produkt in der Zuführeinheit in Lösung oder Suspension verbracht wird oder wobei das Produkt in Lösung oder Suspension der Zuführeinheit zugeführt wird,

- wobei die Temperatur in der Zuführeinheit derart eingestellt ist, dass die Lösung oder die Suspension in einem untersättigten Zustand vorliegt,

- Starten der Kristallisation in einem Kristallisationsschritt durch Verbringen der Lösung oder der Suspension in einen übersättigten Zustand, vorzugsweise durch Anpassen der Temperatur auf eine Zieltemperatur, wobei sich die Gesamtproduktkonzentration $\alpha$ in der Kristallisationseinheit aus der Summe des kristallisierten Feststoffs $\beta$ und des gelösten Produktanteils $\gamma$ ergibt,

- Erfassen der elektrischen Impedanz und der Temperatur an wenigstens zwei Stellen der Vorrichtung in einem Impedanzmessschritt,

- Bestimmen der Gesamtproduktkonzentration $\alpha$ und/oder des Feststoffanteils $\beta$ und/oder des gelösten Produktanteils $\gamma$ und/oder des Verunreinigungsanteils $\delta$ in einem Analyseschritt aus der elektrischen Impedanz, der gemessenen Temperatur und der Kalibriermatrix.

Unter der Anpassung der Temperatur wird ein Erhitzen oder ein Abkühlen der Lösung oder der Suspension verstanden.

Der Vorbereitungsschritt wird vor Inbetriebnahme der Vorrichtung oder bei einem Wechsel der Prozessparameter, beispielsweise bei einem Wechsel des zu reinigenden Produktes und/oder bei einem Wechsel des Lösemittels durchgeführt. Durch die Messungen im Rahmen des Vorbereitungsschrittes wird der Prozess im Hinblick auf sämtliche relevanten Zusammenhänge charakterisiert und parametrisiert.

Durch die Messung der Impedanz und der Temperatur während der Kristallisation können die zuvor genannten Parameter online während der Reinigung bestimmt und überwacht werden. Dadurch, dass an wenigstens zwei Stellen im Prozess gemessen wird, können die an den einzelnen Stellen gemessenen Werte im Hinblick auf deren Plausibilität miteinander verglichen werden.

Zudem können entsprechende Maßnahmen frühzeitig ergriffen werden, wenn die überwachten Größen von den gewünschten Werten abweichen. Dadurch kann die Effizienz des Reinigungsverfahrens erheblich gesteigert werden.

Durch die Überwachung der Gesamtproduktkonzentration $\alpha$ kann diese während des Betriebs durch entsprechendes Nachfüllen des Produktes in die Zuführeinheit im Wesentlichen konstant gehalten werden.

Durch die Überwachung des Feststoffanteils $\beta$ kann der Kristallisationsgrad des zu reinigenden Produkts bestimmt und überwacht werden. Insofern kann der Fortschritt der Reinigung des Produktes ebenso online überwacht werden. Abhängig von dem Kristallisationsgrad und der gewünschten Kristallgröße kann das kristallisierte Produkt aus der Lösung oder der Suspension herausgetrennt werden.

Durch Bestimmung des Verunreinigungsanteils $\delta$ in der Mutterlauge wird gemäß einer Ausgestaltung überwacht, dass der Verunreinigungsanteil $\delta$ nicht zu hoch wird, was, wie eingangs bereits beschrieben, die Effizienz des Reinigungsprozesses senken würde.

Gemäß einer Ausgestaltung wird die Impedanz und die Temperatur an den verschiedenen Stellen des Prozesses laufend erfasst und überwacht. Gemäß einer weiteren Ausgestaltung wird die Temperatur und die Impedanz an den verschiedenen Stellen des Prozesses in regelmäßigen oder unregelmäßigen Abständen erfasst.

Gemäß einer weiteren Ausgestaltung wird an den verschiedenen Stellen des Prozesses die gleiche Größe, beispielsweise die Gesamtproduktkonzentration $\alpha$ bestimmt. Besonders vorteilhaft ist es, wenn an verschiedenen Stellen des Prozesses unterschiedliche Größen bestimmt werden.

Beispielsweise wird in der Zuführeinheit die Gesamtproduktkonzentration $\alpha$ bestimmt und überwacht und in der Kristallisationseinheit wird der Feststoffanteil $\beta$ bestimmt und überwacht und optional wird in der Rückführeinheit der Verunreinigungsanteil $\delta$ bestimmt und überwacht.

Besonders bevorzugt werden an jeder Messstelle, an der ein Impedanzsensor und ein Temperatursensor angeordnet ist, sämtliche relevanten Größen Gesamtproduktkonzentration $\alpha$ und Feststoffanteil $\beta$ und gelöster Produktanteil $\gamma$ und Verunreinigungsanteil $\delta$ bestimmt und überwacht.

Zur Erfassung des Zusammenhangs zwischen der elektrischen Impedanz der Lösung oder der Suspension und der Temperatur und/oder der Gesamtproduktkonzentration $\alpha$ in der Lösung oder der Suspension und/oder dem Feststoffanteil $\beta$ und/oder der Verunreinigungsanteil $\delta$ wird gemäß einer Ausgestaltung ein lineares Regressionsmodell verwendet. Die gemessenen Werte der elektrischen Permitivität $\varepsilon_r$, und der Temperatur T sind dabei Eingangsparameter, die gewichtet werden, sodass sich der Ausgangsparameter der Gesamtproduktkonzentration $\alpha$ ergibt.

Gemäß einer weiteren vorteilhaften Ausgestaltung des Verfahrens werden zur Bestimmung der Gesamtproduktkonzentration $\alpha$ und/oder des Feststoffanteils $\beta$ und/oder des gelösten Produktanteils $\gamma$ und/oder des Verunreinigungsanteils $\delta$ zusätzlich Randbedingungen berücksichtigt, die sich aus der Anordnung der Temperatursensoren und der Impedanzsensoren im Prozess ergeben. Eine Randbedingung ist beispielsweise die,

dass die Gesamtproduktkonzentration $\alpha$, also die Summe aus dem Feststoffanteil $\beta$ und dem gelösten Anteil $\gamma$ des Produktes im Verlauf des Prozesses, insbesondere in der Zuführeinheit und der Kristallisationseinheit, identisch ist. Eine andere Randbedingung ist die, dass der gelöste Anteil $\gamma$ des Produktes sowie der Verunreinigungsanteil $\delta$ in der Kristallisationseinheit und in der optionalen Rückführeinheit nahezu identisch sind. Eine weitere Randbedingung ist die, dass der Feststoffanteil $\beta$ des Produktes in der optionalen Rückführeinheit näherungsweise Null ist.

Besonders bevorzugt wird gemäß einer Ausgestaltung die Einhaltung wenigstens einer der zuvor genannten Randbedingungen überwacht, wobei die Steuerung des Reinigungsprozesses in Abhänigkeit der Einhaltung der wenigstens einen überwachten Randbedingung erfolgt.

Gemäß einer nächsten Ausgestaltung des Verfahrens wird mit der elektrischen Impedanz die Permittivität und/oder die elektrische Leitfähigkeit der Lösung oder der Suspension bestimmt. Es wird damit ausgenutzt, dass sich die Leitfähigkeit und/oder die Permittivität der Lösung oder Suspension ändert, wenn das Produkt kristallisiert.

Gemäß einer weiteren bevorzugten Ausgestaltung wird aus den gemessenen Werten der Permittivität der Zeitpunkt bestimmt, zu dem die Kristallbildung in ein Kristallwachstum übergeht. Dazu wird der Gradient der Permittivität bestimmt. Grundsätzlich ist der Gradient in der Phase des Kristallwachstums geringer als der Gradient in der Phase der Kristallbildung. Fällt der Gradient unter einen festgelegten Grenzwert, so geht die Phase der Kristallbildung in die Phase des Kristallwachstums über.

Gemäß einer weiteren Ausgestaltung des Verfahrens wird die Verunreinigungskonzentration $\delta$ in der Mutterlauge überwacht, wobei in der Vorrichtung ein Grenzwert für die Verunreinigungskonzentration $\delta$ vorhanden ist und wobei frisches Lösemittel in die Zuführeinheit nachgefüllt wird oder wobei das Lösemittel zumindest teilweise ausgetauscht wird, wenn die Verunreinigungskonzentration einen Grenzwert überschreitet. Diese Ausgestaltung gewährleistet, dass sich nicht zu viel Verunreinigung in der Lösung oder der Suspension sammelt, wodurch die Effizienz des Reinigungsprozesses gesenkt wird.

Eine weitere Ausgestaltung des Verfahrens zeichnet sich dadurch aus, dass das Produkt derart nachgefüllt wird, dass die Gesamtproduktkonzentration $\alpha$ im Wesentlichen konstant bleibt. Ein Fehler, der auf eine Variation der Gesamtproduktkonzentration $\alpha$ zurückzuführen ist, kann dadurch vermieden werden.

Als eine spezielle Ausführungsform des erfindungsgemäßen Verfahrens wird nachfolgend der Kristallisationsprozess eines organischen Produktes beschrieben. Das beschriebene Verfahren dient dazu, das Produkt aufzureinigen. Am Ende des Produktionsvorganges liegt das Produkt herstellungsbedingt noch nicht in einer ausreichenden Reinheit vor. Vielmehr weist das Produkt eine Reinheit von ca. 95 % auf. Die restlichen 5 % sind Verunreinigungen durch Produktionsrückstände wie z. B. Katalysatoren. Die vorliegende Reinheit von 95 % ist nicht ausreichend für die weitere Verarbeitung des Produkts und wird deshalb mit Hilfe des Kristallisationsprozesses auf mindestens 95,5 %, besonders bevorzugt auf mindestens 99,5 %, aufgereinigt. Für andere Produkte gelten natürlich andere vorliegende und gewollte Reinheitswerte.

In dem hier beschriebenen Beispiel wird die Kristallisation in einem kontinuierlich betriebenen Prozess durchgeführt. Dazu wird das in Lösemittel gelöst vorliegende Produkt in die Zuführeinheit gegeben, der sogenannte Feed. Die Lösung bzw. Suspension weist hier in diesem Beispiel eine Temperatur von ca. 40 °C auf. Die Lösung bzw. Suspension fließt nun von der Zuführeinheit in die Kristallisationseinheit. Die Kristallisationseinheit kann in einfachster Form beispielsweise als temperiertes Rohr realisiert sein. Die Temperierung dient dabei zur Kühlung der Lösung bzw. Suspension, um diese in Übersättigung zu treiben und somit das Einsetzen der Kristallisation zu initiieren. Dabei muss die Länge des Rohrs und die Temperierung des Rohrs so gewählt werden, dass die Lösung bzw. Suspension, die durch dieses Rohr fließt, am Ende des Rohrs die für die Kristallisation notwendige Temperatur erreicht oder unterschritten hat. Im vorliegenden Beispiel für das organische Produkt wird eine Temperatur von ca. -20 °C oder kälter angestrebt, damit möglichst wenig Produkt in flüssiger Form in der Lösung bzw. Suspension verbleibt und die Effizienz des Prozesses somit hoch ist. Der Prozess funktioniert auch mit höheren Temperaturen, aber dann entsteht weniger Feststoff und die Effizienz des Prozesses ist geringer. Am Ende des Reaktors erfolgt dann die Trennung der Feststoffe von der verbleibenden Lösung bzw. Suspension. Dies erfolgt in einfachster Weise beispielsweise mit Hilfe einer Nutsche oder einem Sieb, das regelmäßig entnommen und entleert wird.

Gemäß einer vorteilhaften Ausgestaltung sind mindestens zwei parallele Stränge realisiert, die abwechselnd mit der Lösung bzw. Suspension aus dem Reaktor durchströmt werden. Während das eine Sieb in einem Strang entleert wird, kann das andere in einem anderen Strang filtern.

Dem kontinuierlichen Prozess geschuldet, wird der Großteil der nach dieser Filterung verbliebenen Lösung wieder auf die für den Zulauf zur Kristallisationseinheit notwendige Temperatur erwärmt. Diese notwendige Temperatur entspricht der Temperatur der Lösung bzw. Suspension am Ende des vorhergehenden Produktionsprozesses. Auch diese Erwärmung geschieht im einfachsten Fall durch ein temperiertes Rohr mit ausreichender Länge und Temperierung. Um eine Akkumulation von Flüssigkeit im Prozess zu vermeiden, wird die Rückführung der gefilterten Lösung genau um das Volumen reduziert, das dem Volumen der aus dem Prozess in den Zulauf gelangenden Lösung bzw. Suspension abzüglich des Volumens des entnommenen Feststoffs entspricht.

Das Monitoring des Kristallisationsprozesses und die darauf aufbauende Steuerung des Prozesses, erfolgt nun mit Hilfe der Messung der elektrischen Impedanz der Lösung bzw. Suspension an mindestens zwei Stellen in diesem Beispielprozess. In der vorliegend beschriebenen Ausgestaltung der Erfassung des Produkts wird in der Zuführeinheit gemessen. Dort gibt die gemessene elektrische Impedanz zusammen mit der dort gemessenen Temperatur Aufschluss darüber, welche Gesamtproduktkonzentration $\alpha$ in der Zuführeinheit vorliegt.

Aus den mehrdimensionalen, insbesondere dreidimensionalen, Kalibriermatrizen kann die Gesamtproduktkonzentration $\alpha$ im Rahmen der Messgenauigkeit für diese Messstelle ermittelt werden. Da auch die Temperatur bekannt ist, kann anhand der Löslichkeitskurve, die ebenfalls aus der Kalibrierung bekannt ist, ermittelt werden, ob das Produkt an dieser Stelle wie gewünscht vollständig in Lösung vorliegt, oder ob Feststoffanteile des Produkts vorliegen. Im letzteren Fall führt das dazu, dass der Anteil des bereits als Feststoff vorliegenden Produkts im Kristallisationsprozess nicht weiter aufgereinigt wird und somit das Endprodukt kontaminiert. Für den Beispielprozess wäre dies ein immenser Schaden. Eine weitere sinnvolle Messstelle in der beschriebenen Ausgestaltung ist das Ende der Kristallisationseinheit. Hier wird ebenfalls aus der gemessenen elektrischen Impedanz die vorliegende Gesamtproduktkonzentration $\alpha$ bestimmt. Logischerweise muss diese an dieser Stelle gleich dem Wert aus der Zuführeinheit sein. Diese Rahmenbedingung ermöglicht es, die Messung der elektrischen Impedanz störende Einflüsse zu kompensieren, indem die Werte an diesen beiden Messstellen durch Offset-Verschiebung gleichgesetzt werden. Weiterhin kann am Ende der Kristallisationseinheit anhand der gemessenen Temperatur und der bekannten Löslichkeitskurve der Feststoffanteil $\beta$ quantifiziert werden. So kann überprüft werden, dass der gewünschte Feststoffanteil $\beta$ tatsächlich in der Kristallisationseinheit entsteht. Entsteht zu wenig Feststoffanteil $\beta$, wird die Kühlung der Kristallisationseinheit angepasst, im Detail wird die Kühlung verstärkt.

An beiden erwähnten Messstellen lässt sich ebenfalls mit Hilfe der mehrdimensionalen, insbesondere dreidimensionalen, Kalibriermatrix die Konzentration der gelösten Verunreinigung bestimmen. Dadurch kann man in der beschriebenen Ausgestaltung beobachten, wie sich durch kontinuierliche Kristallisation und die Rückführung der gefilterten Lösung in die Zuführeinheit die Konzentration an Verunreinigungen akkumuliert. Die Messungen an beiden Stellen ist deshalb sinnvoll, weil dadurch die Messunsicherheit verbessert werden kann und nur so in der beschriebenen Ausgestaltung Aussagen zur Verunreinigungskonzentration < 1% gemacht werden können. Die Rückführung der gefilterten Lösung macht keinen Sinn mehr, wenn die Konzentration an Verunreinigungen ein kritisches Niveau überschreitet. Dieses kritische Niveau kann im Vorfeld durch Laboranalysen bestimmt werden. Typische Werte für dieses kritische Niveau liegen im Bereich < 10%. Wird das kritische Niveau erreicht, wird die gefilterte Lösung so lange nicht zurückgeführt, sondern verworfen und die Zuführeinheit stattdessen mit sauberem Lösemittel gefüllt, bis die Verunreinigungskonzentration wieder auf einen deutlich unter dem kritischen Niveau liegenden Wert abgesunken ist.

Es gibt nun eine Vielzahl von Möglichkeiten die erfindungsgemäße Vorrichtung und das erfindungsgemäße Verfahren auszugestalten und weiterzuentwickeln. Verwiesen wird dazu auf die den unabhängigen Patentansprüchen nachgeordneten Ansprüche sowie auf die nachfolgende Beschreibung von bevorzugten Ausführungsbeispielen in Verbindung mit der Zeichnung.

In der Zeichnung zeigen

Fig. 1  ein schematisches Ausführungsbeispiel einer Vorrichtung zur Reinigung eines Produktes,

Fig. 2  eine Anordnung zur Impedanzmessung,

Fig. 3  eine Vorrichtung zur Bestimmung der Kalibriermatrix Produktes,

Fig. 4  eine Messpunkte-Matrix zur Charakterisierung des Prozesses,

Fig. 5  einen Zusammenhang zwischen der Leitfähigkeit und der Gesamtproduktkonzentration,

Fig. 6  eine Zusammenhang zwischen der Permittivität und der Gesamtproduktkonzentration,

Fig. 7  ein Modell zur Bestimmung der gewünschten Parameter Feststoffanteil $\beta$, gelöster Produktanteil $\gamma$ und Verunreinigungsanteil $\delta$,

Fig. 8  einen Zusammenhang zwischen Temperatur, Leitfähigkeit und Permittivität,

Fig. 9  eine Ausführungsbeispiel eines Verfahrens zur Reinigung eines Produkts und

Fig. 10  ein weiteres Ausführungsbeispiel eines Verfahrens zur Reinigung eines Produkts

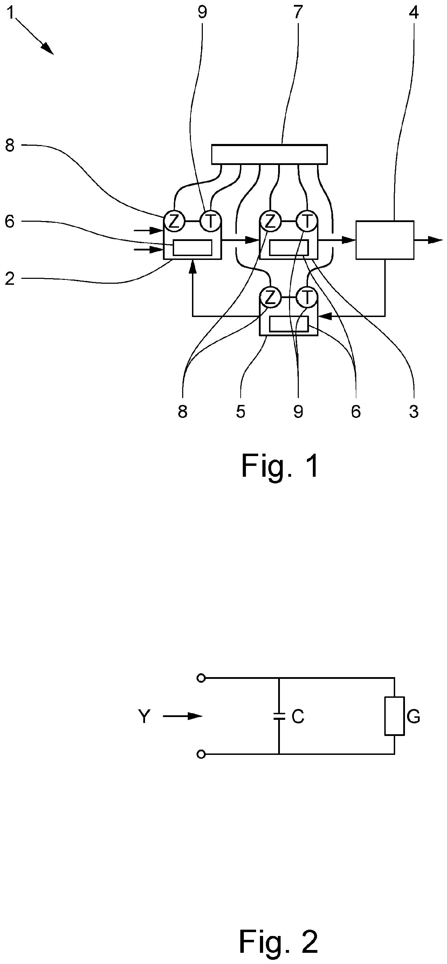

Fig. 1 zeigt ein schematisches Ausführungsbeispiel einer Vorrichtung 1 zur Reinigung eines Produkts, wobei das Produkt mittels chemischer Verfahrenstechnik hergestellt ist, und damit produktionsbedingt einen Verunreinigungsanteil $\delta$ aufweist.

Die Vorrichtung 1 umfasst eine Zuführeinheit 2, wobei die Zuführeinheit 2 ein Lösemittel aufweist, und wobei im Betrieb das Produkt über die Zuführeinheit 2 der Vorrichtung 1 zugeführt wird, sodass in der Zuführeinheit 2 eine Lösung, in der eine Gesamtproduktkonzentration α im Wesentlichen vollständig gelöst, oder eine Suspension mit der Gesamtproduktkonzentration α vorliegt.

Zudem umfasst die Vorrichtung 1 eine Kristallisationseinheit 3, in der das Produkt im Betrieb kristallisiert und damit einen Feststoffanteil β ausbildet, wobei ein weiterer Anteil des Produktes als gelöster Produktanteils γ vorliegt.

Weiterhin weist die Vorrichtung 1 eine Trenneinheit 4 auf, in der das kristallisierte Produkt von der Lösung oder der Suspension getrennt wird.

Die Trenneinheit 4 ist über eine Rückführeinheit 5 mit der Zuführeinheit 2 verbunden, sodass im Betrieb die Lösung oder die Suspension der Zuführeinheit 2 wieder zugeführt wird. Außerdem wird in der Trenneinheit 4 der kristallisierte Teil des Produkts aus der Lösung oder der Suspension herausgetrennt.

Dargestellt ist damit insgesamt ein zyklisches System, in dem die das zu reinigende Produkt aufweisende Lösung oder die das zu reinigende Produkt aufweisende Suspension die Vorrichtung 1 durchströmt.

Die Temperatur in der Zuführeinheit 2 und in der Kristallisationseinheit 3 und in der Rückführeinheit 5 wird über eine Temperiereinheit 6 geregelt. Im Betrieb ist die Temperatur in der Zuführeinheit 2 derart geregelt, dass das Produkt vollständig gelöst oder fein verteilt vorliegt. In der Kristallisationseinheit 3 ist die Temperatur derart geregelt, dass Kristallbildung und Kristallwachstum des Produkts stattfinden. In der Rückführeinheit 5 ist die Temperatur typischerweise derart geregelt, dass das Produkt am Ausgang zur Zuführeinheit 2 vollständig gelöst vorliegt.

Weiterhin umfasst die Vorrichtung 1 eine Steuer- und Auswerteeinheit 7.

In der Zuführeinheit 2, in der Kristallisationseinheit 3 und in der Rückführeinheit 5 sind jeweils ein Temperatursensor 8 und ein Impedanzsensor 9 angeordnet, die im Betrieb die Temperatur bzw. die Impedanz in der Zuführeinheit 2, der Kristallisationseinheit 3 und in der Rückführeinheit 5 bestimmen. Aus den gemessenen Werten der Impedanz und der Temperatur kann im Betrieb die zu bestimmende oder überwachende Größe Gesamtproduktkonzentration α und/oder Feststoffanteil β und/oder gelöster Produktanteil γ und/oder Verunreinigungsanteils δ ermittelt werden.

Durch das Vorhandensein der Mehrzahl der Temperatursensoren 8 und Impedanzsensoren 9, insbesondere durch deren Anordnung im Prozess können auch weitere Bedingungen geschaffen werden, die zur Bestimmung der zuvor genannten Parameter genutzt werden können. Durch eine dauerhafte Bestimmung dieser Parameter kann der Kristallisationsprozess besonders vorteilhaft überwacht und effizient gesteuert werden.

Fig. 2 zeigt ein Ausführungsbeispiel einer Anordnung zur Messung der Impedanz einer Flüssigkeit. Dargestellt ist die parallele Anordnung einer Kapazität C und einer elektrischen Leitfähigkeit G.

Die elektrische Impedanz Z wird über die Admittanz Y bestimmt. Es gilt:

$$Y = \frac{1}{Z} \approx G + j\omega C \approx \frac{1}{k}\left(\sigma + j\omega\varepsilon_0\varepsilon_r\right),$$

wobei σ die elektrische Leitfähigkeit und $\varepsilon_r$ die Permittivität ist.

Somit lässt sich aus der Messung der Impedanz sowohl die elektrische Leitfähigkeit σ als auch die Permittivität $\varepsilon_r$ des Mediums bestimmen.

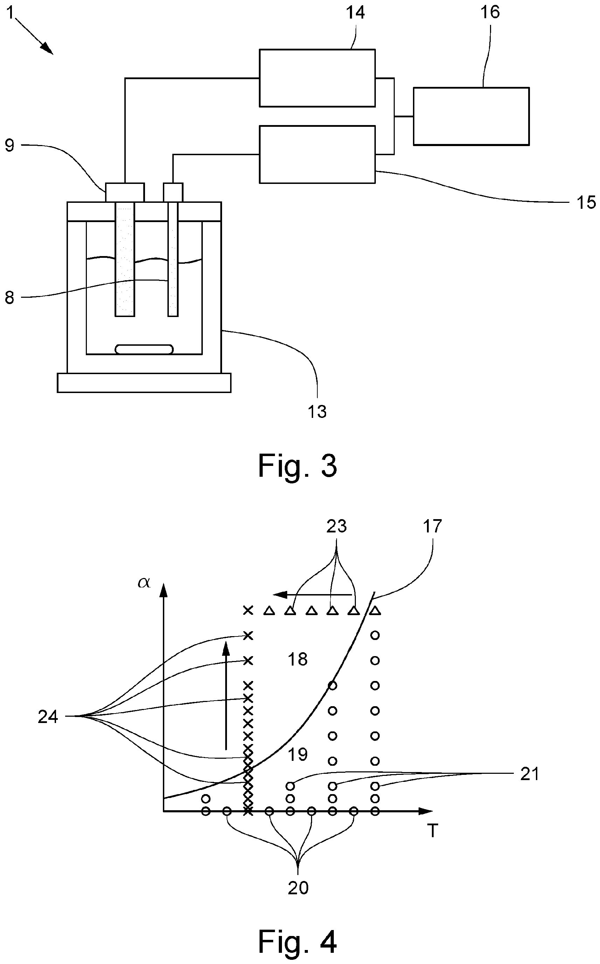

Fig. 3 zeigt die Anordnung einer Vorrichtung zur Bestimmung der Kalibriermatrix eines Produktes, wobei das zu reinigende Produkt in einem Lösemittel in einem Behälter 13 angeordnet ist. Die Vorrichtung umfasst einen Impedanzsensor 9, der im dargestellten Ausführungsbeispiel als Koaxialsensor ausgebildet ist, zur Erfassung der elektrischen Impedanz der Lösung sowie einen Temperatursensor 8, der im dargestellten Ausführungsbeispiel als Pt 1000 oder als Pt 100 ausgebildet ist. Beide Sensoren 8,9 sind in die Lösung bzw. Suspension eingetaucht. Der Impedanzsensor 9 ist mit einem Vektor-Netzwerkanalysator 14 verbunden, der Temperatursensor 8 ist mit einem Multimeter 15 verbunden. Der Netzwerkanalysator 14 und das Multimeter 15 wiederum sind mit einem Computer 16, verbunden, der die Kalibrierwerte auf Basis der gemessenen Impedanz bestimmt.

In Fig. 4 ist die Löslichkeitskennlinie 17 eines Produkts in einem flüssigen Medium dargestellt. Die Kenntnis der Löslichkeitskennlinie 17 des Produkts im gewählten Lösemittel wird benötigt, um anhand der gemessenen Temperatur und der aus der Kennlinie ermittelten Gesamtproduktkonzentration α ableiten zu können, ob und in welcher Konzentration das Produkt in kristalliner Form in der Suspension vorliegt.

Die Löslichkeitskennlinie 17 eines Produkts in dem gewählten Lösemittel ist üblicherweise bekannt und kann daher als gegeben betrachtet werden. Oberhalb der Löslichkeitskurve 17 befindet sich das Produkt im übersättigten Zustand 18. Unterhalb der Löslichkeitskurve befindet sich das Produkt im untersättigten Zustand 19. Mit höherer Gesamtproduktkonzentration α steigt auch die Temperatur, um den übersättigten Zustand 18 herzustellen.

Darüber hinaus sind in dem Koordinatensystem Messpunkte eingetragen, über die das System in einem Vorbereitungsschritt charakterisiert wird.

Über die Messpunkte 20 entlang der x-Achse kann der Einfluss der Temperatur auf die elektrische Impedanz ohne Produktkonzentration ermittelt werden. Kenntnis über den Einfluss der Temperatur auf die elektrische Impedanz in der Lösung, also im vollständig gelösten Zustand kann anhand der Messpunkte 21 im untersättigten Bereich für gleiche Produktkonzentrationen bei unterschiedlichen Temperaturen ermittelt werden. Kenntnis über den Einfluss der Temperatur auf die elektrische Impedanz des Produkts in der Suspension kann anhand der dreieckigen Messpunkte 22 ermittelt werden, die bei gleicher Produktkonzentration unterschiedliche Temperaturen aufweisen. Zudem kann Kenntnis über den Einfluss der Produktkonzentration auf die elektrische Impedanz durch die kreuzförmigen Messpunkte 24 gewonnen werden.

Sämtliche charakterisierende Messpunkte werden weiterhin für unterschiedliche Verunreinigungsanteile $\delta$ bestimmt, womit insgesamt eine mehrdimensionale Messpunktematrix zur Charakterisierung des Systems erzeugt wird.

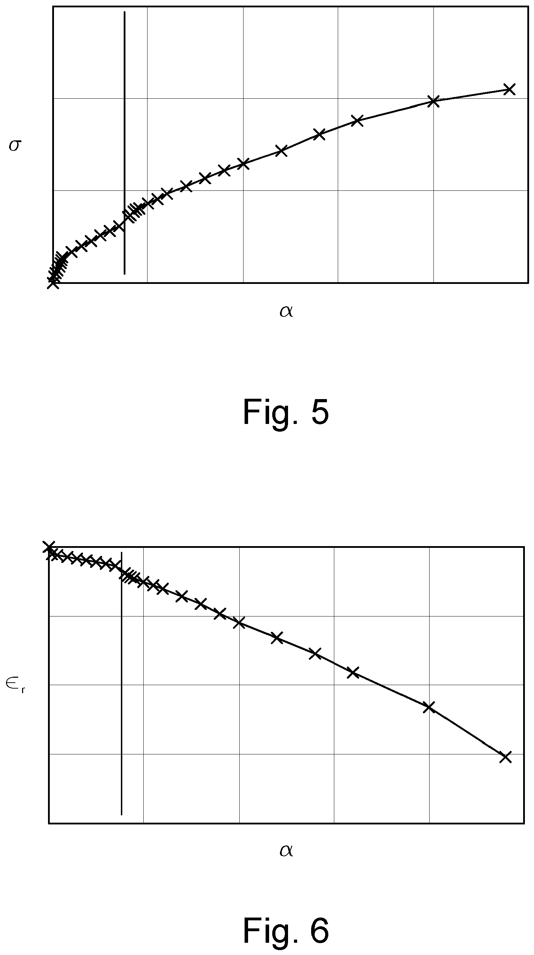

Die mittels der in Fig. 4 dargestellten Messpunkte 20, 21, 22, 23, 24 hergestellten Zusammenhänge können in Form von verschiedenen Kennlinien dargestellt und in der Steuer- und Auswerteeinheit 7 hinterlegt werden. Die Fig. 5 und 6 zeigen beispielhaft für ein organisches Produkt die Abhängigkeit der Leitfähigkeit $\sigma$ von der Gesamtproduktkonzentration $\alpha$ (Fig. 5) sowie die Abhängigkeit der Permittivität $\varepsilon_r$ von der Gesamtproduktkonzentration $\alpha$ (Fig. 6). Die einsetzende Kristallisation ist jeweils durch die senkrechte Linie markiert. Zu erkennen ist, dass sich die Permittivität im Gegensatz zur Leitfähigkeit mit eingesetzter Kristallbildung stärker abhängig von der Gesamtproduktkonzentration ändert. Aus der Steigung der Permittivität lässt sich somit eine Aussage über das Vorliegen von Kristallen in der Suspension treffen.

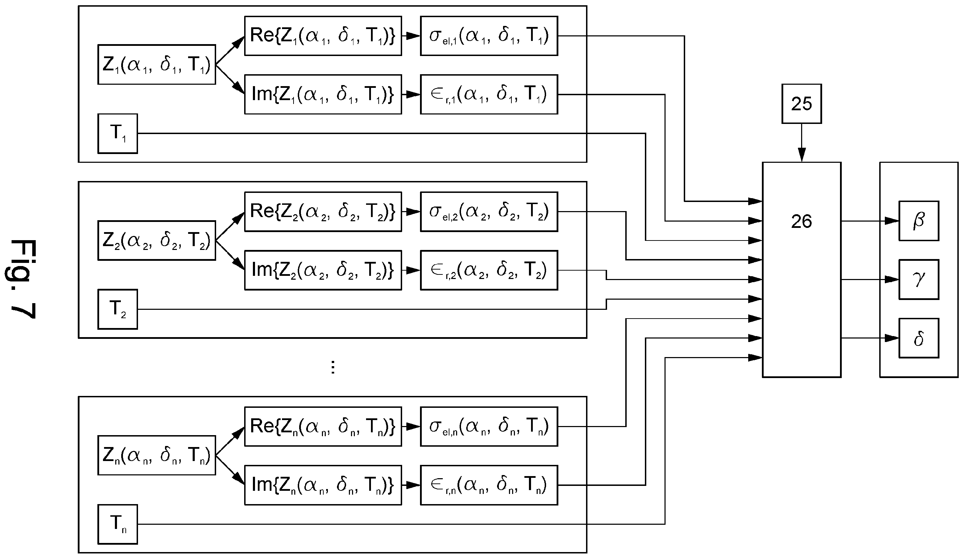

Fig. 7 zeigt ein Modell zur Bestimmung der gewünschten Parameter Feststoffanteil $\beta$, gelöster Produktanteil $\gamma$ und Verunreinigungsanteil $\delta$ basierend auf der gemessenen Impedanz $Z_1$, $Z_2$ bis $Z_n$ sowie den entsprechenden Temperaturen $T_1$, $T_2$ bis $T_n$ an n Messstellen.

Die gemessene elektrische Impedanz an jeder Messstelle weist eine Abhängigkeit von der Gesamtproduktkonzentration $\alpha$, der Verunreinigung $\delta$ und der Temperatur $T$ auf. Zerlegt man die komplexwertige elektrische Impedanz in ihren Real- und Imaginärteil, so weisen auch diese jeweils Abhängigkeiten von $\alpha$, $\delta$ und T auf. Durch die Verknüpfung von mindestens zwei Messstellen bei gleichzeitiger Berücksichtigung der an diesen Messstellen gemessenen Temperatur sowie unter Hinzunahme eines aus dem Prozessvorwissen 25 generierten Prozess-Modells 26 können aus den Werten der Leitfähigkeit und der Permittivität die Zielparameter $\beta$, $\gamma$ und $\delta$ bestimmt werden.

Durch die Verwendung von mehr als zwei Messstellen kann die Genauigkeit der bestimmten Zielparameter noch weiter verbessert werden, da beispielsweise durch Mittelwertbildung oder Plausibilitätsprüfung Messfehler reduziert werden können.

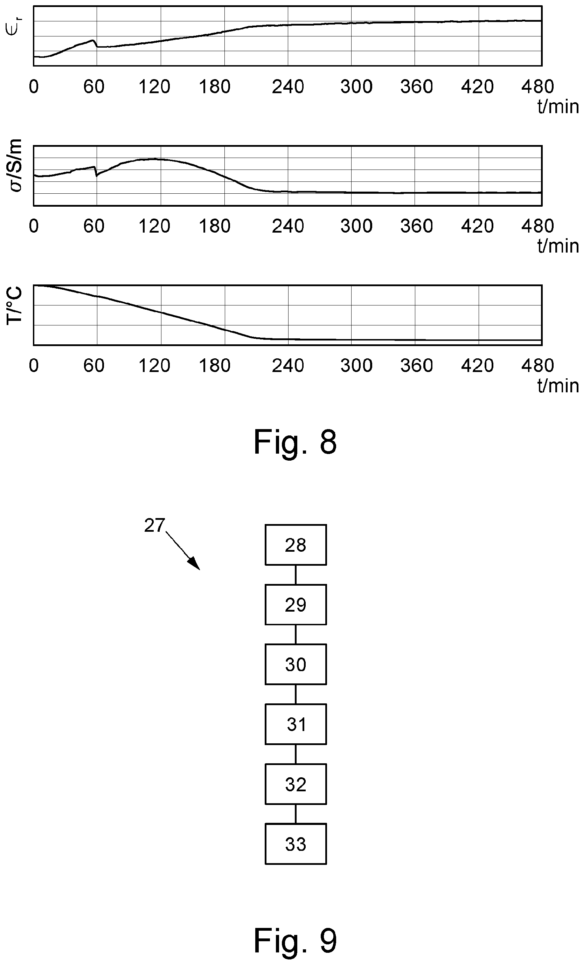

Fig. 8 zeigt die Abhängigkeit der elektrischen Leitfähigkeit und der Permittivität eines Stoffes in einer nicht-wässrigen Lösung bzw. Suspension von der Temperatur. Hier wurde bei einem zunächst vollständig gelösten Stoff, der mit 20 %w in Lösung vorlag, die Temperatur von 60 °C auf -20 °C reduziert, wodurch es zur Kristallisation des Stoffs bei ca. 44 °C kommt. Das Einsetzen der Kristallisation ist durch einen Sprung im Verlauf der elektrischen Leitfähigkeit und der Permittivität erkennbar. Die Kurve zeigt darüber hinaus, dass sich der Gradient der Permittivität nach Einsetzen der Kristallisation zwar ändert, aber linear bleibt, während der Gradient der elektrischen Leitfähigkeit bzgl. des Vorzeichens variiert.

Mit Erreichen einer annähernd konstanten Temperatur in der Kristallisationseinheit nähert sich die Permittivität langsam einem Endwert. In dieser Phase liegt ein langsames Kristallwachstum vor, bei dem nicht die Menge an kristallinem Stoff zunimmt, sondern die Kristallgröße an sich. Anhand dieser ausklingenden Kurve kann ein Betreiber des Prozesses entscheiden, ab wann der Kristallisationsprozess technisch abgeschlossen ist und die gewollte Kristallmenge und -größe vorliegt.

Fig. 9 zeigt ein erstes Ausführungsbeispiel eines Verfahrens 27 zur Reinigung eines Produktes mit einer Vorrichtung 1, wobei die Vorrichtung 1 wie in Fig. 1 beschrieben ausgebildet ist, wobei das Produkt durch ein chemisches Verfahren hergestellt ist, und wobei das Produkt einen Verunreinigungsanteil $\delta$ aufweist.

In einem Vorbereitungsschritt 28 des Verfahrens 27 wird der Zusammenhang zwischen der elektrischen Impedanz der Lösung oder der Suspension und der Temperatur und/oder der Produktkonzentration $\alpha$ in der Lösung oder Suspension und/oder dem Kristallisationsgrad $\beta$ und/oder der Verunreinigungskonzentration $\delta$ erfasst.

Aus dem erfassten Zusammenhang wird eine Kalibriermatrix bestimmt 29, durch die im Betrieb die gewünschten Parameter bestimmt werden.

Während des Betriebs der Vorrichtung werden die folgenden Schritte durchgeführt:
In einem Zuführschritt 30 wird der Zuführeinheit das Produkt zugeführt, wobei das Produkt in der Zuführeinheit in Lösung oder Suspension verbracht wird oder wobei das Produkt in Lösung oder Suspension der Zuführeinheit zugeführt wird.

Die Temperatur in der Zuführeinheit ist dabei derart eingestellt, dass die Lösung oder die Suspension in einem untersättigten Zustand vorliegt,

In einem Kristallisationsschritt 31 wird die Kristallisation durch Anpassen der Temperatur angeregt, wobei die Gesamtproduktkonzentration $\alpha$ sich aus der Summe des rekristallisierten Feststoffs $\beta$ und des gelösten Produktanteils $\gamma$ ergibt.

In einem Impedanzmessschritt 32 wird die elektrische Impedanz und die Temperatur an wenigstens zwei Stellen der Vorrichtung erfasst.

Zudem wird in einem Analyseschritt 33 die Gesamtproduktkonzentration $\alpha$ und/oder der Feststoffanteils $\beta$ und/oder der gelöste Produktanteil $\gamma$ und/oder des Verunreinigungsanteils $\delta$ aus der elektrischen Impedanz, der gemessenen Temperatur und der Kalibriermatrix bestimmt.

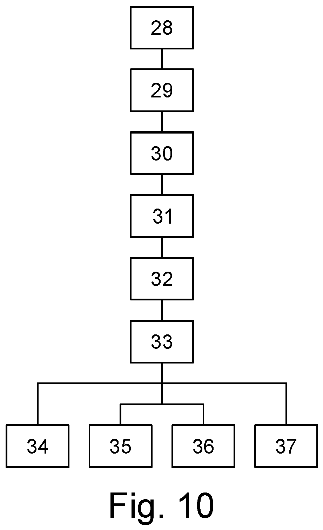

Fig. 10 zeigt ein weiteres Ausführungsbeispiel des erfindungsgemäßen Verfahrens. Basierend auf der bereits beschriebenen Bestimmung der Gesamtprodukt-konzentration $\alpha$ und/oder des Feststoffanteils $\beta$ und/oder des gelöste Produktanteils $\gamma$ und/oder des Verunreinigungsanteils $\delta$ wird die Steuerung des Prozesses zur Erhöhung der Effizienz angepasst.

Im Detail wird der kristalline Feststoffanteil $\beta$ entnommen 34, wenn ein ausreichender Kristallisationsgrad und eine ausreichende Kristallgröße vorliegt.

Zudem wird Lösemittel in die Zuführeinheit 2 nachgefüllt 35 oder das Lösemittel wird teilweise ausgetauscht 36, wenn die Verunreinigungskonzentration einen Grenzwert überschreitet.

Darüber hinaus wird das Produkt derart in die Zuführeinheit 2 nachgefüllt 37, dass die Gesamtprodukt-konzentration $\alpha$ in der Lösung oder in der Suspension während des Betriebs im Wesentlichen konstant bleibt.

## Bezugszeichen

1　　Vorrichtung zur Reinigung eines Produkts
2　　Zuführeinheit
3　　Kristallisationseinheit
4　　Trenneinheit
5　　Rückführeinheit
6　　Temperiereinheit
7　　Steuer- und Auswerteeinheit
8　　Temperatursensor
9　　Impedanzsensor
10　Koaxialsensor
11　innere Elektrode
12　äußere Elektrode
13　Behälter
14　Vektor-Netzwerkanalysator
15　Multimeter
16　Computer
17　Löslichkeitskennlinie
18　übersättigter Zustand
19　untersättigter Zustand
20　Messpunkte
21　Messpunkte
22　Messpunkte
23　Messpunkte
24　Messpunkte
25　Prozessvorwissen
26　Prozessmodell
27　Verfahren zur Reinigung eines Produktes
28　Vorbereitungsschritt
29　Bestimmen einer Kalibriermatrix
30　Zuführschritt
31　Kristallisationsschritt
32　Impedanzmessschritt
33　Analyseschritt
34　Entnahme des kristallinen Feststoffanteils
35　Nachfüllen von Lösemittel
36　Austausch von Lösemittel
37　Zuführen des Produkts in die Zuführeinheit

## Patentansprüche

1.　Vorrichtung (1) zur Reinigung eines Produktes mittels Kristallisation, wobei das Produkt vorzugsweise durch ein chemisches Verfahren hergestellt ist und wobei das Produkt einen Verunreinigungsanteil $\delta$ aufweist, umfassend

　eine Zuführeinheit (2) mit einem Lösemittel, wobei im Betrieb das Produkt über die Zuführeinheit (2) der Vorrichtung (1) zugeführt wird, sodass in der Zuführeinheit (2) eine Lösung, in der die Gesamtproduktkonzentration $\alpha$ im Wesentlichen vollständig gelöst, oder eine Suspension mit der Gesamtproduktkonzentration $\alpha$ vorliegt, eine Kristallisationseinheit (3), in der das Produkt im Betrieb kristallisiert und damit einen Feststoffanteil $\beta$ ausbildet, wobei ein weiterer Anteil des Produktes als gelöster Produktanteil $\gamma$ vorliegt, eine Trenneinheit (4), in der das kristallisierte Produkt von der Lösung oder der Suspension getrennt wird, eine Temperiereinheit (6), über die die Temperatur zumindest in der Zuführeinheit (2) und/oder der Kristallisationseinheit (3) geregelt werden kann, und weiterhin umfassend eine Steuer- und Auswerteeinheit (7), **dadurch gekennzeichnet, dass** an wenigstens zwei Stellen der Vorrichtung (2) jeweils ein Temperatursensor (8) und ein Impedanzsensor (9) angeordnet ist, wobei die Temperatursensoren (8) und die Impedanzsensoren (9) mit der Steuer- und Auswerteeinheit (7) verbunden sind und **dass** die Steuer- und Auswerteeinheit (7) derart eingerichtet ist, dass sie im Betrieb die Gesamtproduktkonzentration $\alpha$ und/oder die Konzentration des Feststoffanteils $\beta$ und/oder die Konzentration des gelösten Produktanteils $\gamma$ und/oder die Konzentration des Verunreinigungsanteils $\delta$ unter Berücksichtigung der Messwerte der Temperatursensoren und der Impedanzsensoren bestimmt.

2.　Vorrichtung (1) nach Anspruch 1, **dadurch gekennzeichnet, dass** die Trenneinheit (4) über eine Rückführeinheit (5) mit der Zuführeinheit (2) verbunden ist, sodass im Betrieb die Lösung oder die Suspension durch die Zuführeinheit (2) in die Kristallisationseinheit (3) in die Trenneinheit (4) und durch die Rückführeinheit (5) wieder in die Zuführeinheit (2) fließt.

3.　Vorrichtung (1) nach Anspruch 1 oder 2, **dadurch gekennzeichnet, dass** in der Zuführeinheit (2) ein erster Impedanzsensor (9) und ein erster Temperatursensor (8) angeordnet ist und dass in der Kristallisationseinheit (3) ein zweiter Impedanzsensor (9) und ein zweiter Temperatursensor (8) angeordnet ist, und dass vorzugsweise in der Rückführeinheit (5), sofern diese vorhanden ist, ein dritter Impedanzsensor (9) und ein dritter Temperatursensor (8) angeordnet ist.

4. Vorrichtung (1) nach einem der Ansprüche 1 bis 3, **dadurch gekennzeichnet, dass** die Steuer- und Auswerteeinheit (7) im Betrieb ein Verfahren gemäß einem der Ansprüche 5 bis 10 durchführt.

5. Verfahren (27) zur Reinigung eines Produktes mit einer Vorrichtung (1) nach einem der Ansprüche 1 bis 4, wobei das Produkt vorzugsweise durch ein chemisches Verfahren hergestellt ist, und wobei das Produkt einen Verunreinigungsanteil $\delta$ aufweist, **dadurch gekennzeichnet,**

> **dass** in einem Vorbereitungsschritt (28) der Zusammenhang zwischen der elektrischen Impedanz der Lösung oder der Suspension und der Temperatur und/oder der Gesamtproduktkonzentration $\alpha$ in der Lösung oder der Suspension und/oder dem Feststoffanteil $\beta$ und/oder der Verunreinigungsanteil $\delta$ erfasst wird,
> wobei aus dem erfassten Zusammenhang eine Kalibriermatrix bestimmt wird (29) und
> **dass** während des Betriebs der Vorrichtung die folgenden Schritte durchgeführt werden:
>
> > - in einem Zuführschritt (30) wird der Zuführeinheit das Produkt zugeführt, wobei das Produkt in der Zuführeinheit in Lösung oder Suspension verbracht wird oder wobei das Produkt in Lösung oder Suspension der Zuführeinheit zugeführt wird,
> > - wobei die Temperatur in der Zuführeinheit derart eingestellt ist, dass die Lösung oder die Suspension in einem untersättigten Zustand vorliegt,
> > - Starten der Kristallisation in einem Kristallisationsschritt (31) durch Verbringen der Lösung oder der Suspension in einen übersättigten Zustand, vorzugsweise durch Anpassen der Temperatur auf eine Zieltemperatur, wobei sich die Gesamtproduktkonzentration $\alpha$ in der Kristallisationseinheit aus der Summe des kristallisierten Feststoffs $\beta$ und des gelösten Produktanteils $\gamma$ ergibt,
> > - Erfassung der elektrischen Impedanz und der Temperatur an wenigstens zwei Stellen der Vorrichtung in einem Impedanzmessschritt (32),
> > - Bestimmen der Gesamtproduktkonzentration $\alpha$ und/oder des Feststoffanteils $\beta$

und/oder des gelösten Produktanteils $\gamma$ und/oder des Verunreinigungsanteils $\delta$ in einem Analyseschritt (33) aus der elektrischen Impedanz, der gemessenen Temperatur und der Kalibriermatrix.

6. Verfahren (27) nach Anspruch 5, **dadurch gekennzeichnet, dass** zur Bestimmung der Gesamtproduktkonzentration $\alpha$ und/oder des Feststoffanteils $\beta$ und/oder des gelösten Produktanteils $\gamma$ und/oder des Verunreinigungsanteils $\delta$ zusätzlich Randbedingungen berücksichtigt werden, die sich aus der Anordnung der Temperatursensoren und der Impedanzsensoren im Prozess ergeben.

7. Verfahren (27) nach Anspruch 5 oder 6, **dadurch gekennzeichnet, dass** mit der elektrischen Impedanz die Permittivität und/oder die elektrische Leitfähigkeit der Lösung oder der Suspension bestimmt wird.

8. Verfahren (27) nach einem der Ansprüche 5 bis 7, **dadurch gekennzeichnet, dass** nach Einsetzen der Kristallisation das Kristallwachstum überwacht wird.

9. Verfahren (27) nach einem der Ansprüche 5 bis 8, **dadurch gekennzeichnet, dass** die Verunreinigungskonzentration $\delta$ in der Mutterlauge überwacht wird und dass in der Vorrichtung (1) ein Grenzwert für die Verunreinigungskonzentration hinterlegt ist und dass Lösemittel in die Zuführeinheit (2) nachgefüllt wird (35) oder dass das Lösemittel zumindest teilweise ausgetauscht wird (36), wenn die Verunreinigungskonzentration den Grenzwert überschreitet.

10. Verfahren (27) nach einem der Ansprüche 5 bis 9, **dadurch gekennzeichnet, dass** das Produkt derart nachgefüllt wird, dass die Gesamtproduktkonzentration $\alpha$ in der Lösung oder in der Suspension im Wesentlichen konstant bleibt.

Fig. 1

Fig. 2

Fig. 3

Fig. 4

σ

α

# Fig. 5

∈r

α

# Fig. 6

Fig. 7

Fig. 8

Fig. 9

28

29

30

31

32

33

34    35    36    37

Fig. 10

Europäisches
Patentamt

European
Patent Office

Office européen
des brevets

**EUROPÄISCHER RECHERCHENBERICHT**

**Nummer der Anmeldung**

**EP 22 17 9097**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | NL 43 578 C (DE VEENIGIG HET PROEFSTATION VOOR DE JAVA-SUIKERINDUSTRIE) 15. Juli 1938 (1938-07-15) * Anspruch 1; Abbildungen 1-22 * ----- | 1-10 | INV. B01D9/00 G01N27/02 |
| X,D | CN 109 030 303 A (UNIV CHINA PETROLEUM BEIJING) 18. Dezember 2018 (2018-12-18) | 1,4 | |
| A | * Ansprüche 1-7; Abbildung 1 * ----- | 2,3,5-10 | |
| X | EP 2 902 774 A1 (SEUFFER GMBH & CO KG [DE]) 5. August 2015 (2015-08-05) | 1,4 | |
| A | * Ansprüche 1-9; Abbildung 2 * ----- | 2,3,5-10 | |
| A | DE 20 2011 101482 U1 (ROBERT SEUFFER GMBH & CO KG [DE]) 7. September 2012 (2012-09-07) * Absatz [0073] * ----- | 1-10 | |

**RECHERCHIERTE SACHGEBIETE (IPC)**

B01D
G01N
G01R

Der vorliegende Recherchenbericht wurde für alle Patentansprüche erstellt

| Recherchenort | Abschlußdatum der Recherche | Prüfer |
|---|---|---|
| München | 30. November 2022 | García Alonso, Nuria |

**ANHANG ZUM EUROPÄISCHEN RECHERCHENBERICHT**
**ÜBER DIE EUROPÄISCHE PATENTANMELDUNG NR.**                    EP 22 17 9097

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-11-2022

| Im Recherchenbericht angeführtes Patentdokument | Datum der Veröffentlichung | Mitglied(er) der Patentfamilie | Datum der Veröffentlichung |
|---|---|---|---|
| NL 43578 C | 15-07-1938 | KEINE | |
| CN 109030303 A | 18-12-2018 | KEINE | |
| EP 2902774 A1 | 05-08-2015 | KEINE | |
| DE 202011101482 U1 | 07-09-2012 | DE 202011101482 U1 | 07-09-2012 |
| | | EP 2533035 A1 | 12-12-2012 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 109030303 A